# DEMANDE DE BREVET EUROPEEN

(11) **EP 0 652 441 A1**
(43) Date de publication de la demande: **10.05.1995**
(21) Numéro de dépôt: 94402495.9
(22) Date de dépôt: 04.11.1994
(51) Int. Cl.: G01R 15/18, H01F 41/04

(54) **Bobine de Rogowski utilisable dans une installation électrique avec enveloppe métallique à la terre et procédé de fabrication d'une telle bobine**

(30) Priorité: 08.11.1993 FR 9313259
(71) Demandeur: GEC ALSTHOM T ET D SA, F-75116 Paris (FR)
(72) Inventeur: Dupraz, Jean-Pierre, F-69003 Lyon (FR)
(74) Mandataire: Fournier, Michel

(57) **Abrégé**

Bobine de Rogowski utilisable notamment dans une installation électrique avec enveloppe métallique à la terre, comprenant un premier support torique (1) à la surface duquel est disposée au moins une première hélice métallique (2), une extrémité de l'hélice étant reliée à un conducteur de retour, caractérisée en ce que le conducteur de retour est constitué par une seconde hélice métallique (12) placée sur un second support torique disposé près du premier support torique.

## Description

La présente invention concerne une bobine de Rogowski utilisable notamment pour la mesure de l'intensisité électrique à l'intérieur d'une installation électrique comprenant une enveloppe métallique cylindrique remplie de gaz diélectrique et mise à la terre, à l'intérieur de laquelle est placé un conducteur électrique axial maintenu par des supports isolants. Une telle installation est aussi désignée par les termes installation blindée.

Un but de l'invention est de définir une bobine de Rogowski qui, traversée par le conducteur axiale précité, permette la mesure de l'intensité traversant ce conducteur.

On connaît, par le document DE-A-1791011, une bobine de Rogowski comprenant un tore sur lequel est bobiné un enroulement.

Un tel tore présente l'inconvénient que le bobinage ne présente pas une symétrie axiale; or, si une bobine n'est pas parfaitement symétrique axialement, la mesure dépend de la position du conducteur traversant le tore et de son orientation.

Un but de la présente invention est de définir une bobine ayant une parfaite symétrie axiale.

Par ailleurs, l'auto-inductance de la bobine n'est pas nulle; or, la précision d'une mesure de courant au moyen d'une bobine de Rogowski est d'autant meilleure que l'auto-inductance de la bobine est plus faible.

Un autre but de l'invention est de réaliser une bobine de Rogowski ayant une auto-inductance extrêmement faible.

Un autre but de la présente invention est de définir une installation électrique de type avec enveloppe à la terre comprenant une bobine de Rogowski selon l'invention, pour permettre la mesure du courant du conducteur de l'installation.

L'invention a pour objet une bobine de Rogowski utilisable notamment dans une installation électrique avec enveloppe métallique à la terre, comprenant un premier support torique à la surface duquel est disposée au moins une première hélice métallique, une extrémité de l'hélice étant reliée à un conducteur de retour, caractérisée en ce que le conducteur de retour est constitué par une seconde hélice métallique placée sur un second support torique disposé près du premier support torique.

L'invention a également pour objet une bobine de Rogowski utilisable notamment dans une installation électrique avec enveloppe métallique à la terre, comprenant un premier support torique à la surface duquel est disposée au moins une première hélice métallique, une extrémité de l'hélice étant reliée à un conducteur de retour, caractérisée en ce que conducteur de retour est constitué par une seconde hélice bobinée en sens inverse et superposée à la première hélice avec interposition d'une couche isolante.

L'invention a également pour objet un procédé de réalisation d'une bobine de Rogowski utilisable notamment dans une installation électrique avec enveloppe métallique à la terre, caractérisée en ce qu'il comprend les opérations suivantes:
- on coupe une longueur donnée d'une tige cylindrique en matériau isolant, contenant ou non un conducteur axial,
- on métallise la surface de ladite tige,
- on réalise à la surface de la tige, par voie mécanique ou chimique, une hélice métallique,
- on soude des conducteurs aux extrémités de l'hélice,
- on cintre la tige de manière à réaliser un tore, les jonctions des deux conducteurs à l'hélice étant aussi voisins que possible.
   L'invention a également pour objet un procédé de réalisation d'une bobine de Rogowski utilisable notamment dans une installation électrique avec enveloppe métallique à la terre, caractérisé en ce qu'il comprend les opérations suivantes:
- on coupe une longueur donnée d'une tige cylindrique en matériau isolant,
- on métallise la surface extérieure de la tige,
- on réalise à la surface de la tige une hélice métallique, par voie mécanique ou chimique,
- on soude deux conducteurs aux extrémités de l'hélice,
- on recouvre la tige d'un dépôt isolant,
- on métallise la surface extérieure de la tige,
- on réalise, par voie mécanique ou chimique, à la surface de la tige, une seconde hélice métallique à pas inverse de l'hélice mentionnée précédemment,
- on soude deux conducteurs aux extrémités de la seconde hélice,
- on relie entre eux deux conducteurs des deux hélices,
- on cintre la tige de manière à réaliser un tore, les extrémités des deux autres conducteurs des hélices étant aussi proches que possible.

L'invention a également pour objet une installation électrique avec enveloppe métallique à la terre à l'intérieur de laquelle règne un gaz isolant et comprenant un conducteur axial maintenu par des cônes isolants, caractérisée en ce qu'elle comprend une bobine de Rogowski du type précité, fixée à l'intérieur d'une gorge pratiquée à l'intérieur d'un anneau en appui contre l'enveloppe.

L'invention a également pour objet une installation électrique avec enveloppe métallique à la terre à l'intérieur de laquelle règne un gaz isolant et comprenant un conducteur axial maintenu par des cônes isolants, caractérisée en ce qu'elle comprend une bobine de Rogowski du type précité, fixée à l'intérieur d'un cône isolant.

De préférence, la fixation de la bobine est effectuée par collage.

L'invention est expliquée maintenant par la description de plusieurs modes de mise en oeuvre de l'invention en référence au dessin annexé dans lequel:
- la figure 1 est une vue en élévation d'une bobine de Rogowski, avant cintrage, dont le conducteur de retour est un conducteur axial, selon l'art antérieur précité,
- la figure 2 est une vue de la bobine de la figure 1 après cintrage,
- la figure 3 est une vue en élévation d'une bobine de Rogowski selon un premier mode de réalisation de l'invention dans lequel le conducteur de retour est une seconde bobine bobinée en sens inverse,
- la figure 4 est une vue partielle en coupe d'une bobine de Rogowski selon une variante de l'invention,
- la figure 5 illustre la réalisation mécanique d'une hélice métallique sur une tige isolante,
- la figure 6 est une vue partielle en coupe axiale d'une installation de type blindé munie d'une bobine de Rogowski fixée selon un premier mode de fixation,
- la figure 7 est une vue partielle en coupe axiale d'une installation blindée comprenant une bobine de Rogowski fixée selon un autre mode de fixation.

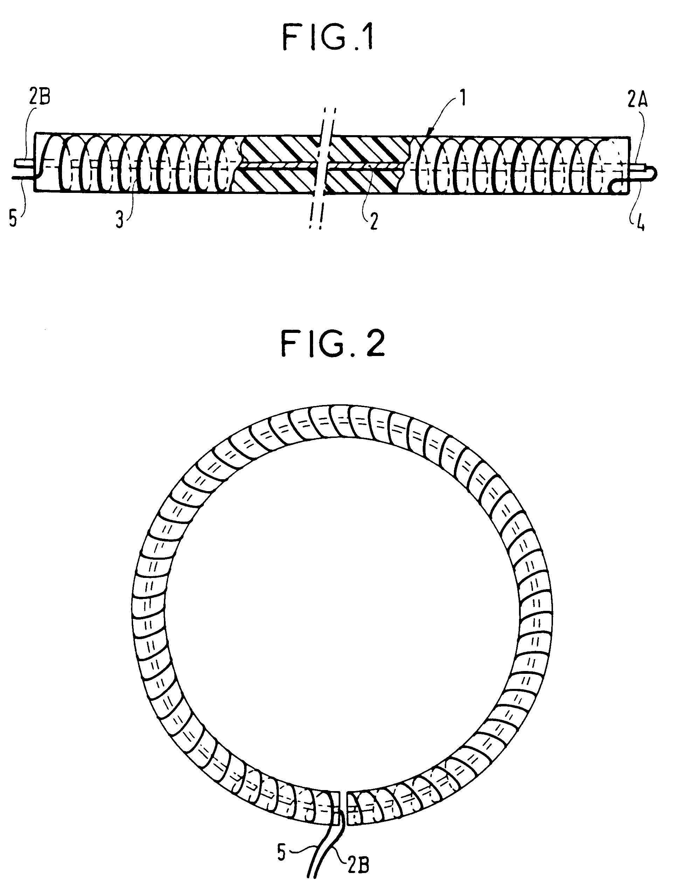

Les figures 1 et 2 illustrent l'art antérieur et montrent une tige cylindrique 1 en matériau isolant, par exemple en matériau composite à base de résine époxy chargé de fibre de verre; un conducteur métallique 2 est disposé dans l'axe de cette tige; les extrémités 2A et 2B du conducteur 2 dépassent de la tige; à la surface de la tige est réalisée une hélice métallique 3 selon un procédé décrit plus loin. A l'une des extrémité de l'hélice est soudé un conducteur 4 qu'on relie électriquement à l'extrémité 2A du conducteur 2. A l'autre extrémité de l'hélice est soudé un conducteur 5; les conducteurs 2B et 5 constituent les bornes de la bobine de Rogowski. Pour être utilisée dans une installation électrique blindée, la tige 1 est cintrée selon une circonférence, comme le montre la figure 2, les extrémités 2B et 5 de la bobine étant aussi proches que possible. Une telle bobine de Rogowski ne présente pas de symétrie axiale.

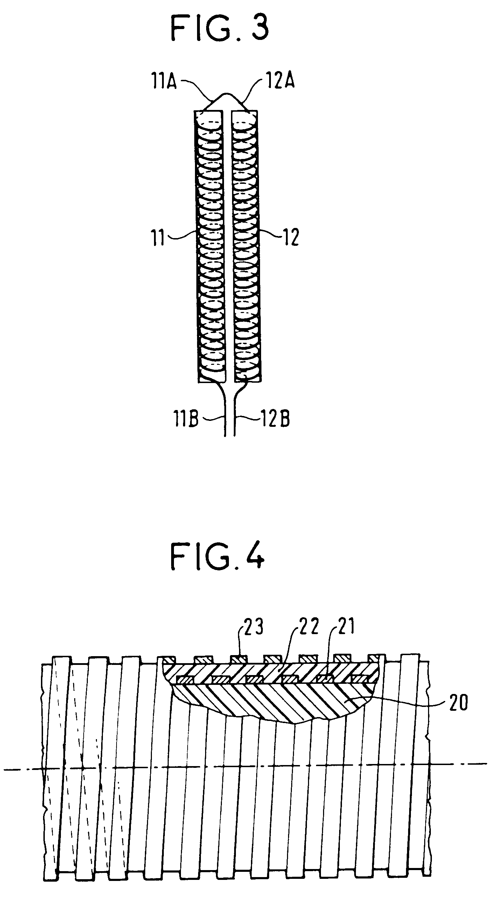

Dans la figure 3, la bobine de l'invention comprend une première bobine 11 réalisée comme la bobine de la figure 1, mais sans conducteur axial; le conducteur de retour est une seconde bobine 12 enroulée à pas inverse de la bobine 11 et disposée à côté de la première bobine de sorte que l'auto-inductance de l'ensemble soit voisin de zéro. Une borne 11A de la première bobine est reliée à une borne 12A de la seconde bobine; les extrémités 11B et 12B des bobines 11 et 12 constituent les bornes de la bobine de Rogowski et sont placés aussi près que possible l'une de l'autre.

Dans une variante de réalisation de l'invention, illustrée dans la figure 4, la bobine de Rogowski comprend une tige en matériau isolant 20 sur laquelle il a été réalisé par voie mécanique une première hélice 21; puis, on a recouvert cette hélice d'une couche isolante 22 et réalisé sur cette couche une seconde hélice métallique 23 bobinée à pas inverse du pas de l'hélice 21. Les deux hélices sont mises en série, des conducteurs sont soudées aux bornes et la tige est cintrée en cercle comme précédemment.

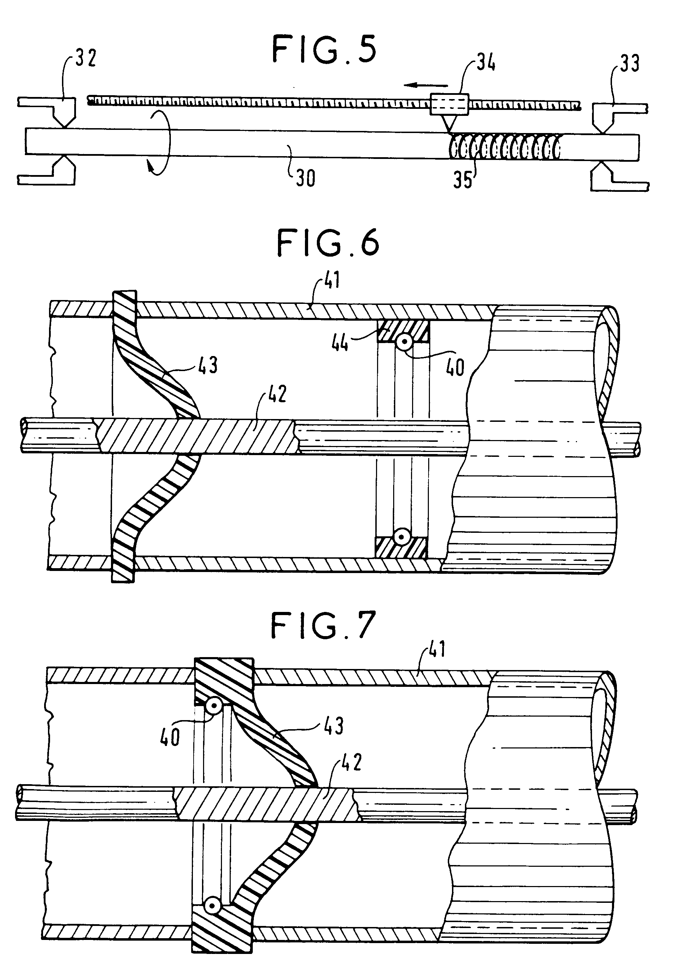

La réalisation des hélices peut se faire mécaniquement, comme le montre la figure 5.

La tige isolante est tout d'abord métallisée par un procédé connu, par exemple par métallisation sous vide, de manière à obtenir une couche homogène. Le métal choisi est avantageusement le cuivre et l'épaisseur comprise entre 50 et 300 millièmes de millimètres.

Comme le montre la figure 5, la tige isolante 30 est prise entre les mors 32 et 33 d'un tour qui lui communique un mouvement de rotation circulaire autour cde son axe à vitesse angulaire constante. Un outil de gravure 34 est déplacé à vitesse linéaire constante parallèlement à la tige. Une hélice 35 parfaitement régulière est ainsi obtenue; les vitesses de rotation du tour et de translation de l'outil sont choisies pour avoir le nombre de spires désiré; il est facile d'obtenir, avec une tige de longueur 1 mètre, 3500 spires séparées par des intervalles d'un dixième de millimètre, le conducteur ayant près de deux centièmes de millimètre de largeur.

En variante, les hélices sont obtenues par voie chimique, selon les méthodes bien connues des fabricant de circuits imprimés.

La figure 6 illustre un premier mode de fixation de la bobine de Rogowski 40 à l'intérieur d'une installation blindée comprenant une enveloppe métallique cylindrique à la terre 41 et un conducteur axial 42 maintenu par des cônes isolants 43. La bobine de Rogowski 40 est disposée à l'intérieur d'une gorge pratiquée à l'intérieur d'un anneau 44 placé en appui contre l'enveloppe 41 et dont le plan est dans une section droite de l'enveloppe. La fixation est réalisée de préférence par collage.

La figure 7 montre une variante de réalisation dans laquelle la bobine de Rogowski 40 est placée dans une gorge pratiquée dans un cône isolant 43 et également fixée par collage.

L'invention trouve application dans la mesure du courant des installations de type à enveloppe métallique à la terre.

## Revendications

**1/** Bobine de Rogowski utilisable notamment dans une installation électrique avec enveloppe métallique à la terre, comprenant un premier support torique (1) à la surface duquel est disposée au moins une première hélice métallique (2), une extrémité de l'hélice étant reliée à un conducteur de retour, caractérisée en ce que le conducteur de retour est constitué par une seconde hélice métallique (12) placée sur un second support torique disposé près du premier support torique.

**2/** Bobine de Rogowski utilisable notamment dans une installation électrique avec enveloppe métallique à la terre, comprenant un premier support torique (1) à la surface duquel est disposée au moins une première hélice métallique (2), une extrémité de l'hélice étant reliée à un conducteur de retour, caractérisée en ce que conducteur de retour est constitué par une seconde hélice (23) bobinée en sens inverse et superposée à la première hélice avec interposition d'une couche isolante (22).

**3/** Procédé de réalisation d'une bobine de Rogowski utilisable notamment dans une installation électrique avec enveloppe métallique à la terre, caractérisée en ce qu'il comprend les opérations suivantes:
- on coupe une longueur donnée d'une tige cylindrique (30) en matériau isolant, contenant ou non un conducteur axial,
- on métallise la surface de ladite tige,
- on réalise à la surface de la tige, par voie mécanique ou chimique, une hélice métallique (35),
- on soude des conducteurs aux extrémités de l'hélice,
- on cintre la tige de manière à réaliser un tore, les jonctions des deux conducteurs à l'hélice étant aussi voisins que possible.

**4/** Procédé de réalisation d'une bobine de Rogowski utilisable notamment dans une installation électrique avec enveloppe métallique à la terre, caractérisé en ce qu'il comprend les opérations suivantes:
- on coupe une longueur donnée d'une tige cylindrique en matériau isolant,
- on métallise la surface extérieure de la tige,
- on réalise à la surface de la tige une hélice métallique, par voie mécanique ou chimique,
- on soude deux conducteurs aux extrémités de l'hélice,
- on recouvre la tige d'un dépôt isolant,
- on métallise la surface extérieure de la tige,
- on réalise, par voie mécanique ou chimique, à la surface de la tige, une seconde hélice métallique à pas inverse de l'hélice mentionnée précédemment,
- on soude deux conducteurs aux extrémités de la seconde hélice,
- on relie entre eux deux conducteurs des deux hélices,
- on cintre la tige de manière à réaliser un tore, les extrémités des deux autres conducteurs des hélices étant aussi proches que possible.

**5/** Installation électrique avec enveloppe métallique (41) à la terre à l'intérieur de laquelle règne un gaz isolant et comprenant un conducteur axial (42) maintenu par des cônes isolants (43), caractérisée en ce qu'elle comprend une bobine de Rogowski (40) du type précité, fixée à l'intérieur d'une gorge pratiquée à l'intérieur d'un anneau (44) en appui contre l'enveloppe.

**6/** Installation électrique avec enveloppe métallique (41) à la terre à l'intérieur de laquelle règne un gaz isolant et comprenant un conducteur axial (42) maintenu par des cônes isolants (43), caractérisée en ce qu'elle comprend une bobine de Rogowski (40) du type précité, fixée à l'intérieur d'un cône isolant (43).

**7/** Installation selon l'une des revendications 5 et 6, caractérisée ne ce que la fixation de la bobine est effectuéepar collage.
